# FASCICULE DE BREVET EUROPEEN

(11) **EP 3 457 510 B1**
(45) Date de publication et mention de la délivrance du brevet: **08.01.2020**
(21) Numéro de dépôt: 18183716.2
(22) Date de dépôt: 16.07.2018
(51) Int. Cl.: H02H 3/17, G01R 31/02, H02H 5/10, H02H 7/20

(54) **LIAISON ÉLECTRIQUE COMPRENANT UN SYSTÈME DE PROTECTION ÉLECTRIQUE**
ELEKTRISCHER ANSCHLUSS, DER EIN ELEKTRISCHES SCHUTZSYSTEM UMFASST
ELECTRICAL CONNECTION COMPRISING AN ELECTRICAL PROTECTION SYSTEM

(30) Priorité: 18.09.2017 FR 1758600
(43) Date de publication de la demande: 20.03.2019
(73) Titulaire: Airbus Operations S.A.S., 31060 Toulouse (FR)
(72) Inventeur: OMS, Patrick, 31770 COLOMIERS (FR)
(74) Mandataire: Gicquel, Olivier Yves Gérard

(56) Documents cités:
- US-A- 5 101 161
- US-A1- 2012 256 637
- US-A1- 2015 346 262

## Description

La présente invention concerne une liaison électrique comprenant au moins deux câbles électriques pour la transmission d'une haute tension à courant continu à des équipements utilisateurs, ladite liaison comprenant un système de protection électrique pour fournir l'énergie électrique de manière sécurisée.

Une installation électrique d'un aéronef comprend une source d'alimentation électrique reliée à des équipements utilisateurs à alimenter en énergie électrique via des câbles électriques isolés entre eux et agencés dans une gaine de protection.

La puissance électrique consommée dans les aéronefs est en constante augmentation. Cette évolution conduit inévitablement à une élévation des niveaux de tension des sources d'alimentation électrique dans les aéronefs qui étaient classiquement de l'ordre de 28 Volts DC (DC pour direct current : courant continu) vers des tensions de l'ordre de 540Volts DC.

De telles valeurs de tensions font apparaître de nouvelles problématiques dans les aéronefs. Par exemple, des arcs électriques parallèles peuvent apparaître lors d'une fuite de courant hors de la gaine de protection ou entre des câbles de ladite gaine en cas de dégradation de l'isolation électrique de la gaine, de même des arcs électriques séries peuvent apparaître lors d'une rupture d'un conducteur.

Il existe un besoin de sécuriser la fourniture en énergie électrique à haute tension et courant continu à un équipement utilisateur d'un aéronef via une gaine de protection comprenant plusieurs câbles électriques.

L'invention vise à répondre à ce besoin et concerne une liaison électrique comprenant une gaine de protection entourant au moins deux conducteurs où chacun desdits conducteur est adapté à relier une source de tension continue à un équipement utilisateur, chaque conducteur étant entouré d'une enveloppe isolante, la liaison électrique comprenant en outre un système de protection électrique comprenant :
- associé à chaque conducteur :
   ∘ une gaine conductrice arrangée autour de l'enveloppe isolante du conducteur,
   ∘ un coupe-circuit arrangé sur le conducteur et configuré, lorsque activé, pour s'ouvrir et mettre le conducteur hors tension ;
   ∘ un générateur de courant continu connecté à la gaine conductrice et configuré pour générer un courant non nul à réception d'un signal d'activation ; et
   ∘ un ensemble de détection de courant de fuite connecté à la gaine conductrice et au coupe-circuit ;
- un séquenceur fournissant successivement un signal d'activation aux générateurs de courant de la liaison électrique.
l'ensemble de détection d'un conducteur est configuré pour mesurer un courant traversant la gaine conductrice et comparer une tension proportionnelle audit courant à une première plage de valeurs et à une seconde plage de valeurs, l'ensemble de détection activant le coupe-circuit :
- si la tension est en dehors de la première plage de valeurs alors que le générateur de courant génère un courant non nul; ou
- si la tension est en dehors de la seconde plage de valeurs alors que le générateur de courant génère un courant nul.

Une liaison électrique selon l'invention équipée d'un système de protection électrique permet, à l'apparition d'un courant de fuite anormal au niveau d'au moins un des deux conducteurs indiquant une perte d'intégrité de la gaine de protection, d'interrompre (via la coupure d'un ou plusieurs conducteur) toute ou une partie seulement de la transmission énergie après un temps de réaction bref des circuits électroniques. La coupure rapide (quelques millisecondes) de l'énergie électrique évite les dommages par effet thermique (arcs électriques) causées aux matériaux environnants ainsi que l'injection de courant dans les matériaux environnants, ainsi que la propagation de la haute tension HV dans l'environnement autour de la gaine de protection.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
- la figure 1 représente un aéronef comportant une installation électrique ayant une source d'alimentation connectée à une pluralité d'équipements utilisateurs via une liaison électrique selon un mode de réalisation de l'invention ;
- la figure 2 représente un schéma bloc de l'installation électrique représentée à la figure 1, et une représentation d'un système de protection électrique de la liaison électrique selon un mode de réalisation de l'invention, ladite liaison comprenant une gaine de protection et un système de protection électrique ;
- la figure 3 représente une vue en coupe de la gaine de protection de la liaison électrique représentée à la figure 2;
- la figure 4 représente un schéma électrique de l'installation électrique représentée à la figure 2;
- les figures 5a à 5c sont des diagrammes illustrant l'évolution des signaux sur l'installation électrique représentée à la figure 2 lorsque la gaine de protection et ses constituants ne présentent aucun défaut ;
- les figures 6a à 6c sont des diagrammes illustrant l'évolution des signaux sur l'installation électrique représentée à la figure 2 lorsque la gaine de protection présente un premier cas de perte d'intégrité
- les figures 7a à 7c sont des diagrammes similaires aux diagrammes des figures 6a à 6c lorsque la gaine de protection présente un second cas de perte d'intégrité.
- les figures 8a à 8c sont des diagrammes similaires aux diagrammes des figures 6 et 7 lorsque la gaine de protection présente un troisième cas de perte d'intégrité.

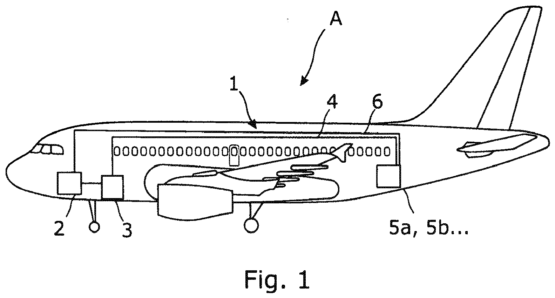

En relation avec les figures 1 à 3, un aéronef A comporte une installation électrique 1 ayant une source d'alimentation 2 en haute tension continue alimentant en énergie au moins deux équipements utilisateurs 5a,5b, où chaque équipement utilisateur est relié à la source d'alimentation 2 via une liaison électrique 100. La liaison électrique 100 comprend une gaine de protection 4 réalisée dans un matériau isolant et au moins deux conducteurs électrique 30 agencés dans la gaine, chaque conducteur 30 reliant la source d'alimentation 2 à un équipement utilisateur 5a,5b.

Afin d'assurer l'isolation entre les conducteurs 30 de la gaine de protection 4, chaque conducteur 30 est enveloppé par une enveloppe isolante 31 et l'intérieur de la gaine de protection 4 est en outre rempli d'un matériau isolant 34.

La source d'alimentation 2 est en outre reliée aux équipements utilisateurs 5a,5b par une ligne de retour de courant 6. Dans la description ci-dessus, par ligne de retour de courant 6, on entend soit un conducteur de retour soit un réseau de retour de courant.

La source d'alimentation 2 en haute tension fournit des tensions HV continues qui peuvent être 2 tensions de même polarité, par exemple 2 fois +540V, ou 2 tension de polarité inverse , par exemple + et - 270V.

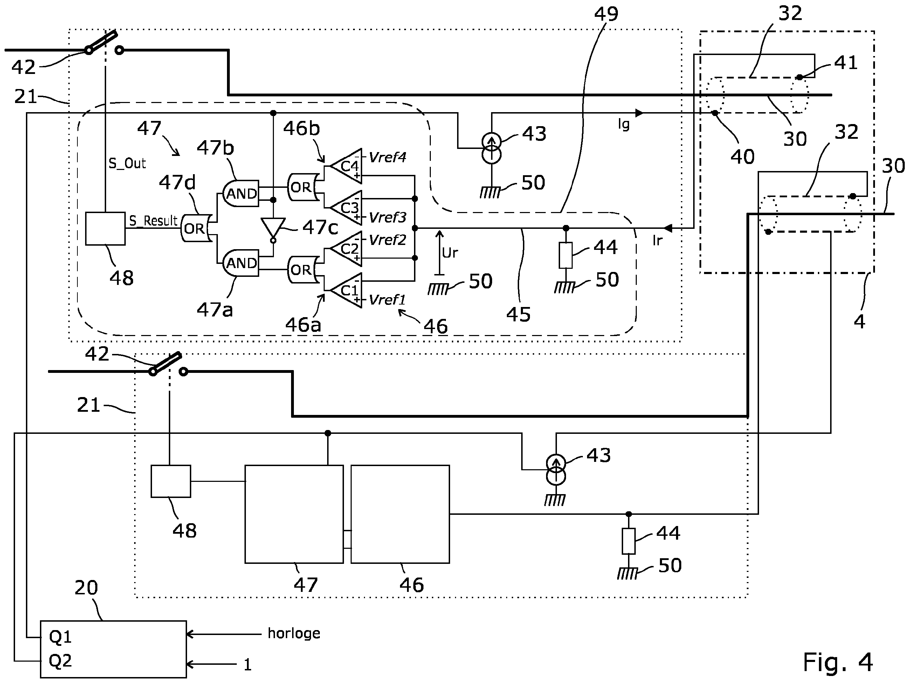

L'aéronef A comprend en outre une structure conductrice (non représentée) qui est formée par tout élément métallique/conducteur de l'aéronef (par exemple : les cadres, les lisses, le châssis du plancher de la cabine) qui est au potentiel de référence et forme la masse 50 (visible sur la figure 4).

Selon l'invention, la liaison électrique 100 comprend un système de protection électrique 3 pour sécuriser la transmission d'énergie électrique de la source d'alimentation 2 vers les équipements utilisateurs 5a, 5b via la gaine de protection 4.

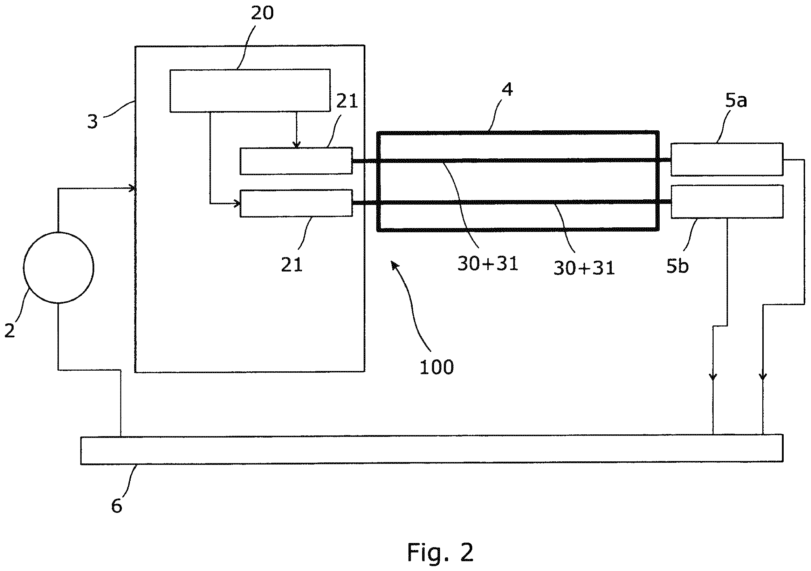

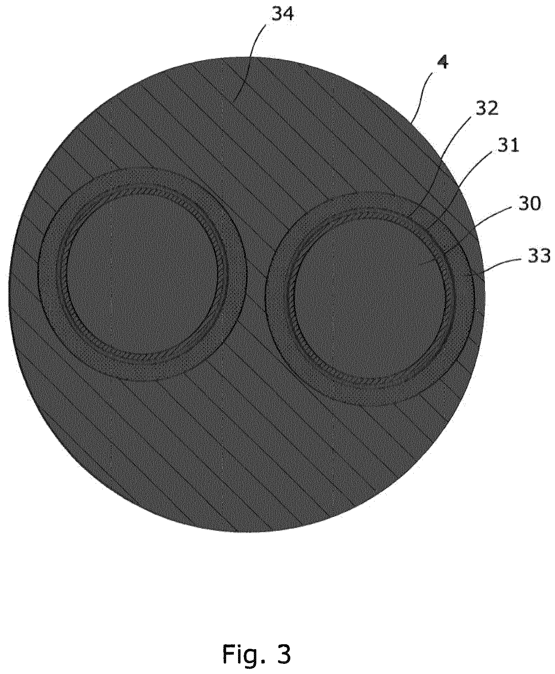

En relation avec les figures 2 et 3, le système de protection électrique 3 comprend un séquenceur 20 et, de manière identique pour chaque conducteur 30 de la liaison :
- une gaine conductrice 32 (par exemple de type treillis métallique) entourée d'un matériau isolant 33, ladite gaine conductrice 32 étant arrangée sur l'enveloppe isolante 31 du conducteur 30 et est directement en contact avec ladite enveloppe isolante 31 (voir figure 3) ; et
- un dispositif d'analyse et de coupure 21, arrangé, par exemple dans un boitier/carte électronique, et qui assure la détection de courant de fuite vers ou hors de la gaine conductrice 32 et l'ouverture du conducteur 30 si une fuite de courant est détectée.

Une fuite de courant se produit dans 3 cas :
- lorsque la gaine de protection 4 ainsi que le matériau isolant 34 sont endommagés et qu'une gaine conductrice 32 se retrouve en contact avec la structure conductrice de l'aéronef A,
- lorsque l'enveloppe isolante 31 d'un des conducteurs 30 est endommagée et qu'un arc électrique ou un contact apparait entre la gaine conductrice 32 et le conducteur 30;
- lorsque le matériau isolant 34 est endommagé, et que deux deux gaines conductrices 32 se retrouvent en contact;

En relation avec la figure 4, le séquenceur 20, par exemple de type microprogrammé, reçoit en entrée un signal d'horloge. Le séquenceur 20 possède une pluralité de voies Q1, Q2, dites sorties, où chaque sortie est associée à un unique conducteur 30 et est connectée au dispositif d'analyse et de coupure 21 dédié à ce conducteur.

Le séquenceur 20 met en œuvre une séquence prédéfinie consistant à activer successivement les sorties Q1, Q2 à la manière d'un chenillard, c'est-à-dire à envoyer successivement le signal d'activation sur les sorties Q1, Q2 (une seule sortie recevant le signal d'activation à un instant donnée).

L'activation successive des sorties Q1, Q2 est rythmée par l'horloge du séquenceur. A titre d'exemple, la fréquence de l'horloge est de 40 Hz, de sorte que chaque sortie Q1, Q2 est activée pendant un temps de 25 millisecondes.

Le dispositif d'analyse et de coupure 21 dédié à un conducteur 30 comprend un coupe-circuit 42, un générateur de courant continu 43 et un ensemble de détection 49 de courant de fuite.

Le coupe-circuit 42 est arrangé sur le conducteur 30 au niveau de l'extrémité amont (côté source d'alimentation) du conducteur 30. De manière connue, le coupe-circuit 42 fonctionne comme un interrupteur qui lorsqu'il reçoit un ordre d'activation, s'ouvre et met ainsi le conducteur 30 hors tension.

Le générateur de courant continu 43 est connecté entre la masse 50 et un point d'injection du courant 40 de la gaine conductrice 32, ledit point d'injection étant, par exemple, situé au niveau de l'extrémité amont (côté source d'alimentation, en aval du coupe-circuit) du conducteur 30.

Le générateur de courant 43 est en outre connecté à la sortie Q1,Q2 du séquenceur 20 dédiée au conducteur 30 de sorte que son fonctionnement dépend de l'activation ou non de ladite sortie :
- si la sortie est activée, le générateur de courant 43 est activé et injecte un courant de polarisation Ig non nul au point d'injection du courant 40, assurant ainsi la polarisation de gaine conductrice 32 ; et
- si la sortie est désactivée, le générateur de courant 43 ne produit aucun courant (Ig=0).

L'ensemble de détection 49 comprend une résistance de mesure de courant 44 de type shunt pour mesurer le courant Ir traversant la gaine conductrice 32 et, connectés entre la résistance 44 et le coupe-circuit 42, un module de comparaison 46 puis un module multiplexeur 47 puis un module de confirmation 48. Les fonctions des modules de comparaison 46 et multiplexeur 47 et du module de confirmation 48 sont, par exemple, mises en œuvre dans un microcontrôleur programmé à cet effet.

La résistance 44, de valeur Rshunt connue, est connectée à une première borne à un point de prélèvement de courant 41 de la gaine conductrice 32 et à une seconde borne à la masse 50. Le point de prélèvement de courant 41 est situé, par exemple, au niveau de l'extrémité aval (côté équipement utilisateur) du conducteur 30. De manière connue, la tension Ur aux bornes de la résistance 44 est proportionnelle à l'intensité Ir traversant la résistance 44 et la gaine conductrice 32, soit Ur = Ir. Rshunt.

Le module de comparaison 46 est connecté à la première borne du shunt 44 via une liaison électrique 45, dite ligne de détection. La tension dans la ligne de détection 45 est la tension Ur proportionnelle à l'intensité Ir.

Le module de comparaison 46 compare la tension Ur dans la ligne de détection 45 à deux plages de valeurs de tensions, dont :
- une plage haute qui est centrée autour d'une valeur attendue de la tension Ur dans la ligne de détection 45 lorsque le générateur de courant 43 est activé et que la gaine de protection 4 ne présente aucun problème de défaut d'isolation. Cette valeur de tension Ur attendue est dite tension maximale Urmax, et
- une plage basse qui est centrée autour de la tension nulle qui correspond à la tension dans la ligne de détection 45 lorsqu'aucun courant n'est injecté dans la gaine conductrice 32.

En valeur absolue, la valeur minimale de la plage haute est supérieure, à la valeur maximale de la place basse.

L'ensemble de détection 49 est ainsi configuré pour mesurer le courant Ir traversant la gaine conductrice 32 en utilisant la résistance 44 de shunt et comparer la valeur de la tension Ur aux bornes de la résistance 44 de shunt, qui est proportionnelle audit courant Ir, à la plage haute et à la plage basse.

Dans un exemple de mode de réalisation illustré en relation avec la figure 4, le module de comparaison 46 comprend deux comparateurs à fenêtre 46a, 46b, chaque comparateur à fenêtre comprenant de manière connue deux comparateurs C1,..,C4 et une porte logique OU recevant en entrée la sortie des deux comparateurs. Dans un exemple où Urmax est positif, l'agencement est le suivant :
- Pour le comparateur à fenêtre de la plage haute 46b :
   - un premier comparateur C4 a sa borne positive d'entrée connectée à la première borne de la résistance 44 et sa borne négative d'entrée connectée à un générateur de tension continu (non représenté) fournissant une tension de référence Vref4 (valeur de tension la plus haute de la plage haute) ;
   - un second comparateur C3 a sa borne négative d'entrée connectée à la première borne de la résistance 44 et sa borne positive d'entrée connectée à un générateur de tension continu (non représenté) fournissant une tension de référence Vref3 (valeur de tension la plus basse de la plage haute) ;
   - la porte logique OU reçoit en entrée la sortie des deux comparateurs C4, C3.
- Pour le comparateur à fenêtre de la plage de valeurs basses 46a :
   - un premier comparateur C2 a sa borne positive d'entrée connectée à la première borne de la résistance 44 et sa borne négative d'entrée connectée à un générateur de tension continu (non représenté) fournissant une tension de référence Vref2 (valeur de tension la plus haute de la plage basse) ;
   - un second comparateur C1 a sa borne négative d'entrée connectée à la première borne de la résistance 44 et sa borne positive d'entrée connectée à un générateur de tension continu (non représenté) fournissant une tension de référence Vref1 (valeur de tension la plus basse de la plage basse) ;
   - la porte logique OU recevant en entrée la sortie des deux comparateurs C2, C1.

Le choix des tensions de références détermine la variation maximale acceptable de Ur, donc de Ir. Les valeurs minimale et maximale de l'intensité Ir prennent en considération le courant injecté Ig ainsi que les courants de fuite normaux et acceptables qui peuvent existent dans une installation électrique d'aéronef.

Le module multiplexeur 47 reçoit en entrée les signaux de sortie des deux comparateurs à fenêtre 46a-b et est en outre connecté à la sortie Q1, Q2 du séquenceur 20 associée au conducteur 30.

Dans un exemple de mode de réalisation illustré en relation avec la figure 4, le module multiplexeur 47 comprend deux portes logiques ET agencées, dont une première porte logique ET 47b recevant la sortie du comparateur à fenêtre dédié à la plage haute 46b et une seconde porte logique ET 47a recevant la sortie du comparateur à fenêtre dédié à la plage basse 46a.

L'entrée de la première porte logique ET 47b est en outre connectée directement à la sortie Q1, Q2 du séquenceur 20 associée au conducteur 30 tandis que l'entrée de la seconde porte logique ET 47a est connectée à ladite sortie Q, Q2 au travers une porte logique NON 47c (qui produit en sortie un signal mis à 1 si son entrée est un signal mis à 0, et inversement)

Une porte logique OU 47d reçoit en entrée les sorties des deux portes logiques ET 47a-b. Le signal de sortie S_Result de la porte logique OU est transmis au module de confirmation 48.

Le module de confirmation 48 reçoit le signal de sortie S_Result et décompte un temps, dit temps de confirmation tc, si le signal S_Result reçu est mis à 1. Si le signal S_Result reste à 1 pendant la durée entière du temps de confirmation tc, alors à l'issue du temps tc, le module de confirmation 48 envoie un signal d'activation S_Out mis à 1 au coupe-circuit 42.

Le coupe-circuit, à la réception du signal S_Out mis à 1, ouvre le conducteur 30.

Le temps de confirmation tc est choisi pour tenir compte du temps de stabilisation de l'électronique à chaque transition entre Q1 et Q2, ainsi que le temps de stabilisation du courant Ig dans la. Ainsi, pour un temps d'activation de la voie de 25 millisecondes (horloge à 40Hz), un temps de confirmation tc de 5 millisecondes est une valeur adaptée.

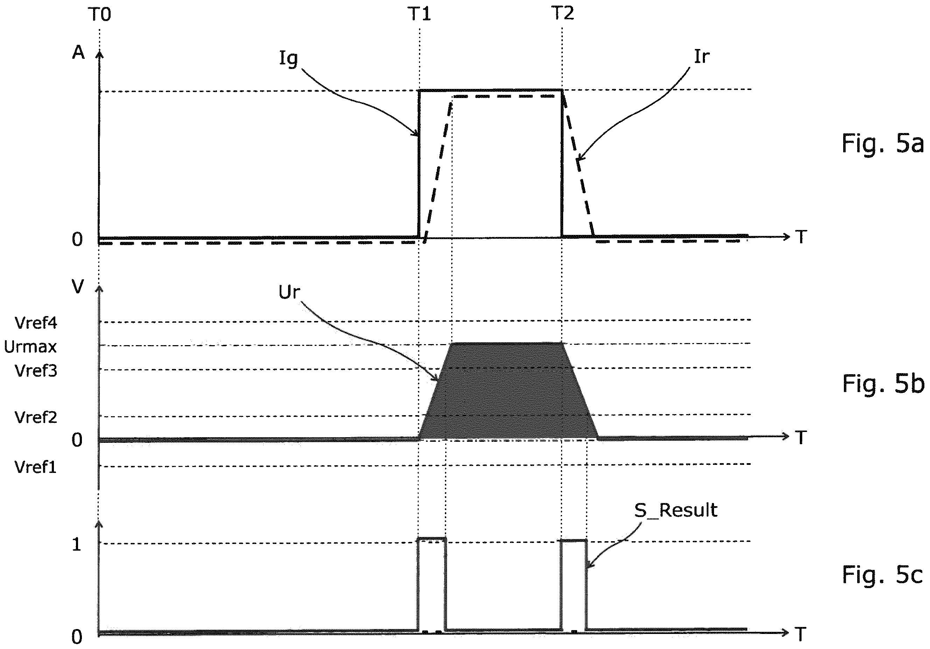

Des exemples de fonctionnement du système de protection selon l'invention sont illustrés en relation avec les figures 5 à 8. Dans ces figures, il est représenté, pour un une installation électrique 1, un exemple d'évolution des signaux Ig et Ir (figure 5-6-7-8 a), Ur (figure 5-6-7-8b) et S_Result/ S_Out (figure 5-6-7-8c), lorsque à partir d'un temps T1 et jusqu'à un temps T2, la sortie du séquenceur associée à la liaison électrique est activée.

### Dans ces exemples :

HV=540 V (l'intensité dans le conducteur est de 30A)
Ig = 1 A
Rshunt = 10 Ohms 10 Watts,
Vref4= 15V
Vref3= 5V,
Vref2= 2,5V
Vref1= -2,5V
Fréquence de l'horloge du séquenceur : 40 Hz
tc = 5 millisecondes.
Urmax est sensiblement égale à 10 Volts (aux courants de fuite normaux près)
Urmin est sensiblement égal à 0 Volts (aux courants de fuite normaux près)

En relation avec les figures 5a-c, on considère un cas où la gaine de protection ne présente aucune défaillance.

D'un temps 0 jusqu'au temps T1, le générateur de courant 43 de la liaison électrique 10 est désactivé et le courant Ig est égal à 0. Ir comme Ur est donc également sensiblement nul.

Le comparateur à fenêtre 46a détecte que Ur est dans la plage basse et fournit un signal de sortie mis à 0.

Le comparateur à fenêtre 46b détecte quant à lui que Ur est hors de la plage haute et fournit un signal de sortie mis à 1.

La porte logique ET 47a associée au comparateur à fenêtre 46a reçoit un signal mis à 0 en provenance du module de comparaison 46 et un signal mis à 1 du séquenceur 20 (du fait de la porte logique NON 47c). Le signal de la porte 47a est donc 0.

La porte logique ET 47b associée au comparateur à fenêtre 46b reçoit un signal mis à 1 en provenance du module de comparaison 46 et un signal mis à 0 du séquenceur 20. Le signal de la porte 47b est donc 0.

Le module de confirmation 48 reçoit un signal S_Result mis à 0 du module multiplexeur 47 et le compte à rebours du temps de confirmation tc n'est pas enclenché.

A partir du temps T1 et jusqu'au temps T2, le générateur de courant 43 injecte le courant Ig dans la gaine conductrice 32 et la valeur de Ig devient immédiatement égale à 1A au temps T1. Entre les temps T1 et T2, le courant Ir tend à atteindre une valeur maximale proche de/ mais inférieure à Ig, mais de manière non instantanée du fait de phénomènes capacitifs. En effet, il faut quelques millisecondes (de l'ordre de 1 à 2 millisecondes) pour que la valeur du courant Ir atteigne sa valeur maximale.

La tension Ur suit la courbe de Ir et atteint sa valeur Urmax au bout de quelques millisecondes.

Durant le retard de quelques millisecondes le comparateur à fenêtre 46b détecte que la tension Ur est hors de la plage haute et fournit un signal de sortie mis à 1.

La porte logique ET 47b reçoit le signal mis à 1 en provenance du module de comparaison 46 et un signal mis à 1 en provenance du séquenceur 20.

Le module de confirmation 48 reçoit un signal S_Result mis à 1 du module multiplexeur 47 et le compte à rebours du temps de confirmation tc démarre. Or, la tension Ur atteint sa valeur maximale Urmax au bout d'un temps inférieur au temps de confirmation tc si bien que le coupe-circuit n'est pas activé (le signal S Out reste à 0).

A parti de T2, le générateur de courant 43 est désactivé et la valeur du courant Ig devient instantanément nulle au temps T2. Ir tend à atteindre la valeur nulle mais de manière non instantanée du fait de phénomènes capacitifs. En effet, il faut quelques millisecondes (de l'ordre de 1 à 2 millisecondes) pour que la valeur du courant Ir devienne nulle.

La tension Ur suit la courbe de Ir est atteint également sa valeur minimale proche de 0 (du fait d'effet parasites) au bout de quelques millisecondes.

Durant le retard de quelques millisecondes le comparateur à fenêtre 46a détecte que la tension Ur est hors de ladite plage et fournit un signal de sortie mis à 1.

La porte logique ET 47a reçoit le signal mis à 1 en provenance du module de comparaison 46 et un signal mis à 1 en provenance de la porte logique NON 47c .

Le module de confirmation 48 reçoit donc un signal S_Result mis à 1 du module multiplexeur et le compte à rebours du temps de confirmation tc démarre. Or, la tension Ur atteint sa valeur minimale proche de 0 au bout d'un temps inférieur au temps de confirmation tc si bien que le coupe-circuit n'est pas activé (le signal S_Out reste à 0).

Le module de confirmation 48 permet ainsi de prendre en compte les phénomènes de stabilisation du courant Ir à l'injection/coupure du courant Ig.

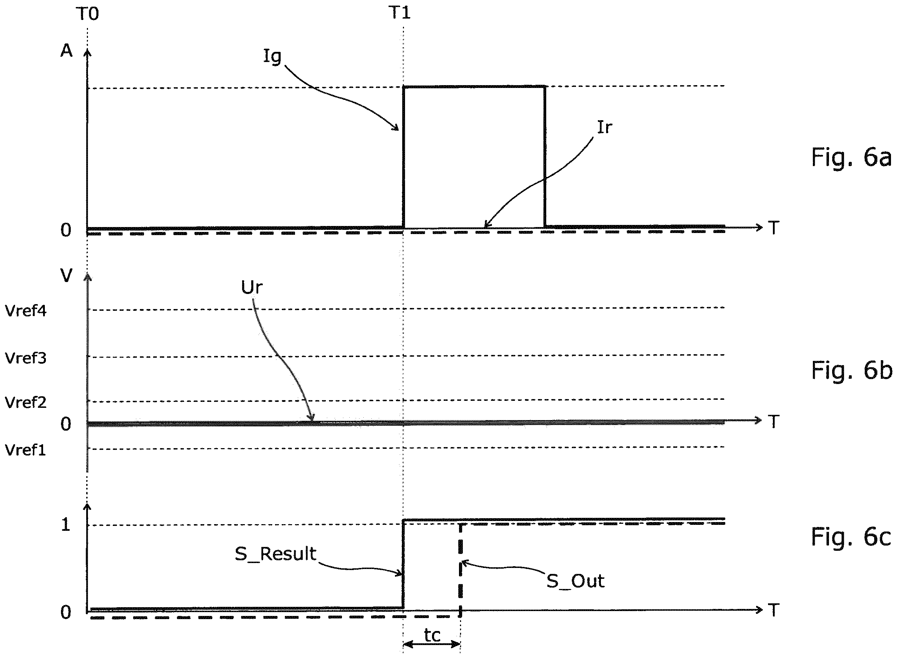

Dans l'exemple des figures 6, on considère un cas où la gaine de protection 4 et où l'enveloppe isolante 33 de la gaine conductrice 32 d'un conducteur 30 sont endommagés si bien que la gaine conductrice 32 est en contact avec la structure de l'aéronef (au potentiel 0V) dès le temps T0.

Du temps T0 jusqu'au temps T1, le générateur de courant 43 est désactivé et la situation est identique à ce qui a été décrit plus haut en relation avec les figures 5 pour la même période de temps.

A partir du temps T1, le générateur de courant 43 injecte le courant Ig dans la gaine conductrice 32 qui prend instantanément la valeur de 1 Ampère. Entre les temps T1 et T2, le courant Ir a une valeur proche de 0 car une majeure partie de Ig s'écoule dans la structure de l'aeronef du fait du contact de la gaine conductrice 32 avec la structure. La tension Ur reste par conséquent à une valeur proche de 0 Volt.

Le comparateur à fenêtre 46b détecte que la tension Ur est hors de la plage haute et fournit un signal de sortie mis à 1.

La porte logique ET 47b reçoit le signal mis à 1 en provenance du module de comparaison 46 et un signal mis à 1 en provenance du séquenceur 20.

Le module de confirmation 48 reçoit donc un signal S_Result mis à 1 du module multiplexeur et le compte à rebours du temps de confirmation tc démarre. A l'issue du temps de confirmation, le module de confirmation envoie un signal d'activation S_Out mis à 1 au coupe-circuit.

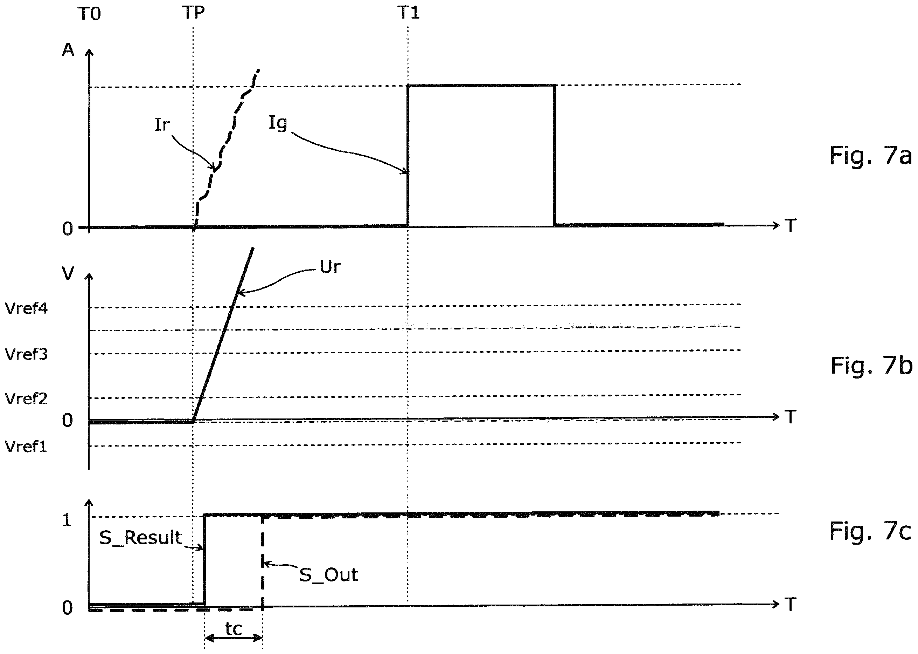

Dans l'exemple des figures 7, on considère un cas où l'enveloppe isolante 31 d'un des conducteurs 30 est endommagé à partir d'un temps Tp situé avant le temps T1, si bien que la gaine conductrice 32 et le conducteur 30 (ou d'une autre liaison) sont en contact.

Du temps T0 jusqu'au temps Tp, le générateur de courant 43 est désactivé et la valeur du courant Ig est nulle. Le module de confirmation 48 reçoit un signal S_Result mis à 0 du module multiplexeur 47.

A partir du temps Tp, le courant Ir suit une pente ascendante lié à une fuite de courant provenant du conducteur 30, tandis que le générateur de courant 43 est désactivé et ne délivre pas de courant. La tension Ur suit une même pente que le courant Ir à partir du temps Tp.

Le comparateur à fenêtre 46a détecte que Ur est hors de la plage basse et fournit un signal mis à 1.

La porte logique ET 47a reçoit un signal mis à 1 en provenance du module de comparaison 46 et un signal mis à 1 de la porte logique NON 47c.

Le module de confirmation 48 reçoit un signal S_Result mis à 1 du module multiplexeur 47 durant un temps supérieur au temps de confirmation tc du module de confirmation et le module de confirmation envoie un signal d'activation S_Out mis à 1 au coupe-circuit.

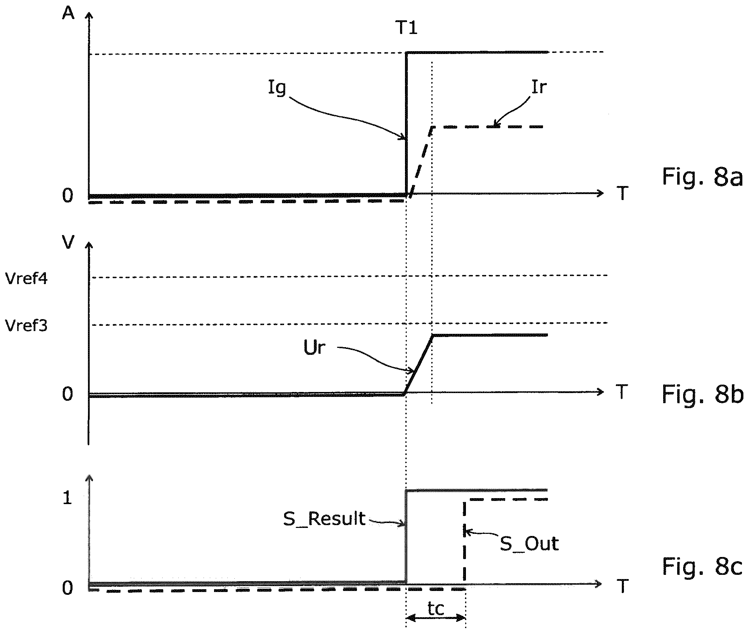

Dans l'exemple des figures 8, on considère un cas où l'isolant 34 sous la gaine de protection 4 est endommagé, si bien que deux gaines conductrices 32 sont en contact dès le temps T0.

Du temps T0 jusqu'au temps T1, le générateur de courant 43 est désactivé et la situation est identique à ce qui a été décrit plus haut en relation avec les figures 5 pour la même période de temps.

A partir du temps T1, le générateur de courant 43 injecte le courant Ig de 1 A qui se réparti dans les deux gaines conductrices 32 car elles sont en contact. Entre les temps T1 et T2, la somme des deux courants Ir tend à atteindre une valeur maximale proche Ig, de manière non instantanée du fait de phénomènes capacitifs.

Les tensions Ur se stabilisent après 1 à 2 ms à une valeur moitié de la valeur normale car les deux résistances de shunt 44 se retrouvent en parallèle.

Le comparateur à fenêtre 46b détecte que la tension Ur est hors de la plage haute et fournit un signal de sortie mis à 1.

La porte logique ET 47b reçoit le signal mis à 1 en provenance du module de comparaison 46 et un signal mis à 1 en provenance du séquenceur 20.

Le module de confirmation 48 reçoit donc un signal S_Result mis à 1 du module multiplexeur 47 et le compte à rebours du temps de confirmation tc démarre. A l'issue du temps de confirmation, le module de confirmation 48 envoie un signal d'activation S_Out mis à 1 au coupe-circuit.

Une liaison électrique 100 selon l'invention équipée d'un système de protection électrique 3 tel que décrit ci-dessus permet, à l'apparition d'un courant de fuite anormal au niveau d'au moins un des deux conducteurs indiquant une perte d'intégrité de la gaine de protection, d'interrompre (via la coupure d'un ou plusieurs conducteur) toute ou une partie seulement de la transmission énergie après un temps de réaction bref des circuits électroniques. La coupure rapide (quelques millisecondes) de l'énergie électrique évite les dommages par effet thermique (arcs électriques) causées aux matériaux environnants ainsi que l'injection de courant dans les matériaux environnants, ainsi que la propagation de la haute tension HV dans l'environnement autour de la gaine de protection.

Dans une variante non représentée, le module de confirmation 48 est connecté à un écran d'affichage à destination d'un utilisateur et le module de confirmation 48 envoie un signal pour afficher une alerte sur l'écran d'affichage simultanément la mise à 1 du signal S_Out pour activer le coupe-circuit.

Le générateur de courant 43 est de préférence limité en tension avec une limitation choisie pour être non dangereuse pour les personnes physique, typiquement inférieure à 50 Volts. Cette option préférentielle permet d'ajouter un degré de protection supplémentaire pour les personnes physiques.

Dans une variante non représentée de l'invention, les dispositifs coupe-circuits 42 des différents dispositifs d'analyse et de coupure de courant 21 sont connectés entre eux de sorte que l'activation d'un seul coupe-circuit 42 provoque l'activation de tous les autres coupe-circuit 42 afin de couper totalement la transmission d'énergie électrique au travers du câble 4.

L'invention a été décrite pour protéger la transmission d'énergie électrique via un câble d'une installation électrique 1 d'un aéronef A. Cependant, l'invention trouve application à tout autre type de véhicule, par exemple un navire ou une automobile.

L'invention a été décrite, notamment via l'exemple illustré à la figure 4, pour une tension HV positive. La modification de l'invention pour prendre en compte d'autres paramètres (tension HV positive ou négative, courant de polarisation Ig positif ou négatif) est à la portée de l'homme du métier.

Les montages décrits pour réaliser les fonctions du module de comparaison 46 et du module multiplexeur 47 ne sont que des exemples de mode de réalisation de l'invention. D'autres montages logiques pourraient être utilisés pour remplir ces fonctions sans sortir du cadre de la présente invention.

Dans une variante de l'invention non représentée sur les figures (le fonctionnement et les schémas électriques de cette variantes sont identiques à ce qui a été décrit plus haut en relation avec les figures 1 à 8), la gaine de protection de la liaison électrique est de type toron. Dans ce cas, les conducteurs électriques sont de type co-axiaux et sont co-routés dans ladite gaine.

Enfin, d'autres types de capteurs de courant pour mesurer le courant Ir traversant la gaine conductrice 32 peuvent être utilisés en lieu et place de la résistance 44. Ces capteurs de courant seront de technologies adaptées aux caractéristiques électriques de la liaison électrique 100.

## Revendications

1. Liaison électrique (100) comprenant une gaine de protection (4) entourant au moins deux conducteurs (30) où chacun desdits conducteur (30) est adapté à relier une source de tension (2) continue à un équipement utilisateur (5a, 5b), chaque conducteur (30) étant entouré d'une enveloppe isolante (31), **caractérisée en ce que** la liaison électrique (100) comprend en outre un système de protection électrique (3) comprenant :
• associé à chaque conducteur (30) :
∘ une gaine conductrice (32) arrangée autour de l'enveloppe isolante (31) du conducteur (30),
∘ un coupe-circuit (42) arrangé sur le conducteur (30) et configuré, lorsque activé, pour s'ouvrir et mettre ledit conducteur (30) hors tension ;
∘ un générateur de courant continu (43) connecté à la gaine conductrice (32) et configuré pour générer un courant non nul (Ig) à réception d'un signal d'activation ; et
∘ un ensemble de détection (49) de courant de fuite connecté à la gaine conductrice (32) et au coupe-circuit (42) ;
• un séquenceur (20) fournissant successivement un signal d'activation aux générateurs de courant (43) de la liaison électrique (100) ;
l'ensemble de détection (49) d'un conducteur (30) est configuré pour mesurer un courant (Ir) traversant la gaine conductrice (32) et
**caractérisé en ce que**
l'ensemble de détection est configuré pour comparer une tension (Ur), proportionnelle audit courant
(Ir),
à une première plage de valeurs et à une seconde plage de valeurs, l'ensemble de
détection (49) activant le coupe-circuit (42) :
- si la tension (Ur) est en dehors de la première plage de valeurs alors que le générateur de courant (43) génère un courant (Ig) non nul ; ou
- si la tension (Ur) est en dehors de la seconde plage de valeurs alors que le générateur de courant (43) génère un courant nul.

2. Liaison électrique (100) selon la revendication 1, **caractérisée en ce que** en valeur absolue, la valeur minimale de la première plage de valeurs est supérieure, à la valeur maximale de la seconde plage de valeurs.

3. Liaison électrique (100) selon l'une quelconque des revendications 1 ou 2, **caractérisée en ce que** le séquenceur comprend une pluralité de sorties (Q1, Q2) où chaque sortie est dédiée à un unique conducteur (30) et est connectée au générateur de courant (43) et à l'ensemble de détection (49) associé audit conducteur.

4. Liaison électrique (100) selon la revendication 1, **caractérisée en ce que** l'ensemble de détection (49) de chaque liaison électrique comprend :
- une résistance (44) ayant une première et une seconde borne, la résistance étant connectée à la gaine conductrice (32) à sa première borne et à une masse (50) à sa seconde borne;
- un module de comparaison (46) connecté à la première borne de la résistance (44) via une liaison électrique, dite ligne de détection (45), et configuré pour comparer la valeur de la tension (Ur) dans la ligne de détection (45) à la première plage de valeurs de tensions et à la seconde plage de valeurs de tensions.

5. Liaison électrique (100) selon la revendication 4, **caractérisée en ce que** le module de comparaison (46) comprend un premier comparateur à fenêtre (46b) pour comparer la valeur de la tension dans la ligne de détection à la première plage de valeurs et un second comparateur à fenêtre (46a) pour comparer la valeur de la tension dans la ligne de détection à la seconde plage de valeurs.

## Patentansprüche

1. Elektrische Verbindung (100) umfassend einen Schutzmantel (4), der mindestens zwei Leiter (30) umgibt, wobei jeder der Leiter (30) geeignet ist, eine Gleichspannungsquelle (2) mit einer Benutzerausrüstung (5a, 5b) zu verbinden, wobei jeder Leiter (30) von einer Isolierhülle (31) umgeben ist, **dadurch gekennzeichnet, dass** die elektrische Verbindung (100) ferner ein elektrisches Schutzsystem (3) umfasst, umfassend:
• in Verbindung mit jedem Leiter (30):
∘ eine leitende Hülle (32), die um die Isolierhülle (31) des Leiters (30) herum angeordnet ist,
∘ einen Schalter (42), der auf dem Leiter (30) angeordnet ist und dazu ausgebildet ist, sich zu öffnen und den Leiter (30) spannungsfrei zu schalten, wenn er aktiviert ist;
∘ einen Gleichstromerzeuger (43), der mit der leitenden Hülle (32) verbunden ist und dazu ausgebildet ist, bei Empfang eines Aktivierungssignals einen Strom ungleich Null (Ig) zu erzeugen; und
∘ eine Leckstrom-Detektionsanordnung (49), die mit der leitenden Hülle (32) und dem Schalter (42) verbunden ist;
• eine Folgesteuerung (20), die nacheinander ein Aktivierungssignal den Stromerzeugern (43) der elektrischen Verbindung (100) bereitstellt;
wobei die Detektionsanordnung (49) eines Leiters (30) dazu ausgebildet ist, einen Strom (Ir) zu messen, der die leitende Hülle (32) durchläuft, und **dadurch gekennzeichnet, dass**
die Detektionsanordnung dazu ausgebildet ist, eine Spannung (Ur), die zu dem Strom (Ir) proportional ist, mit einem ersten Wertebereich und einem zweiten Wertebereich zu vergleichen, wobei die Detektionsanordnung (49) den Schalter (42) aktiviert:
- wenn die Spannung (Ur) außerhalb des ersten Wertebereichs liegt, während der Stromerzeuger (43) einen Strom (Ig) ungleich Null erzeugt; oder
- wenn die Spannung (Ur) außerhalb des zweiten Wertebereichs liegt, während der Stromerzeuger (43) einen Nullstrom erzeugt.

2. Elektrische Verbindung (100) nach Anspruch 1, **dadurch gekennzeichnet, dass** in absoluten Werten der Minimalwert des ersten Wertebereichs höher als der Maximalwert des zweiten Wertebereichs ist.

3. Elektrische Verbindung (100) nach einem der Ansprüche 1 oder 2, **dadurch gekennzeichnet, dass** die Folgesteuerung mehrere Ausgänge (Q1, Q2) umfasst, wobei jeder Ausgang für einen einzelnen Leiter (30) vorgesehen und mit dem Stromerzeuger (43) und der Detektionsanordnung (49), die mit dem Leiter in Verbindung steht, verbunden ist.

4. Elektrische Verbindung (100) nach Anspruch 1, **dadurch gekennzeichnet, dass** die Detektionsanordnung (49) jeder elektrischen Verbindung Folgendes umfasst:
- einen Widerstand (44) mit einem ersten und einem zweiten Anschluss, wobei der Widerstand an seinem ersten Anschluss mit der leitenden Hülle (32) und an seinem zweiten Anschluss mit einer Masse (50) verbunden ist;
- ein Vergleichsmodul (46), das über eine elektrische Verbindung, die Detektionsleitung (45), mit dem ersten Anschluss des Widerstands (44) verbunden ist und dazu ausgebildet ist, den Wert der Spannung (Ur) in der Detektionsleitung (45) mit dem ersten Spannungswertebereich und dem zweiten Spannungswertebereich zu vergleichen.

5. Elektrische Verbindung (100) nach Anspruch 4, **dadurch gekennzeichnet, dass** das Vergleichsmodul (46) einen ersten Fensterkomparator (46b) zum Vergleichen des Werts der Spannung in der Detektionsleitung mit dem ersten Wertebereich und einen zweiten Fensterkomparator (46a) zum Vergleichen des Werts der Spannung in der Detektionsleitung mit dem zweiten Wertebereich enthält.

## Claims

1. Electrical link (100) comprising a protective sheath (4) surrounding at least two conductors (30) in which each of said conductors (30) is suitable for linking a direct voltage source (2) to a user equipment item (5a, 5b), each conductor (30) being surrounded by an insulating jacket (31), **characterized in that** the electrical link (100) also comprises an electrical protection system (3) comprising:
• associated with each conductor (30):
∘ a conductive sheath (32) arranged around the insulating jacket (31) of the conductor (30),
∘ a circuit breaker (42) arranged on the conductor (30) and configured, when activated, to open and power down said conductor (30);
∘ a direct current generator (43) connected to the conductive sheath (32) and configured to generate a non-zero current (Ig) on reception of an activation signal; and
∘ a leakage current detection assembly (49) connected to the conductive sheath (32) and to the circuit breaker (42);
• a sequencer (20) supplying, in succession, an activation signal to the current generators (43) of the electrical link (100);
the detection assembly (49) of a conductor (30) being configured to measure a current (Ir) passing through the conductive sheath (32) and **characterized in that**
the detection assembly is configured to compare a voltage (Ur) proportional to said current (Ir) to a first range of values and to a second range of values, the detection assembly (49) activating the circuit breaker (42):
- if the voltage (Ur) is outside of the first range of values while the current generator (43) generates a non-zero current (Ig); or
- if the voltage (Ur) is outside of the second range of values while the current generator (43) generates a zero current.

2. Electrical link (100) according to Claim 1, **characterized in that**, in absolute value, the minimum value of the first range of values is greater than the maximum value of the second range of values.

3. Electrical link (100) according to either one of Claims 1 and 2, **characterized in that** the sequencer comprises a plurality of outputs (Q1, Q2) in which each output is dedicated to a single conductor (30) and is connected to the current generator (43) and to the detection assembly (49) associated with said conductor.

4. Electrical link (100) according to Claim 1, **characterized in that** the detection assembly (49) of each electrical link comprises:
- a resistor (44) having a first terminal and a second terminal, the resistor being connected to the conductive sheath (32) at its first terminal and to a ground (50) at its second terminal;
- a comparison module (46) connected to the first terminal of the resistor (44) via an electrical link, called detection line (45), and configured to compare the value of the voltage (Ur) in the detection line (45) to the first range of voltage values and to the second range of voltage values.

5. Electrical link (100) according to Claim 4, **characterized in that** the comparison module (46) comprises a first window comparator (46b) for comparing the value of the voltage in the detection line to the first range of values and a second window comparator (46a) for comparing the value of the voltage in the detection line to the second range of values.
